# EUROPEAN PATENT APPLICATION

(11) **EP 4 350 271 A1**
(43) Date of publication of application: **10.04.2024**
(21) Application number: 22815586.7
(22) Date of filing: 24.02.2022
(51) Int. Cl.: F28D 15/02, F28D 15/04

(54) **MANUFACTURING METHOD AND HEAT EXCHANGER**

(30) Priority: 04.06.2021 JP 2021094822; 04.06.2021 JP 2021094823
(71) Applicant: Porite Corporation, Saitama-shi, Saitama 331-0823 (JP); NATIONAL UNIVERSITY CORPORATION TOKAI NATIONAL HIGHER EDUCATION AND RESEARCH SYSTEM, Nagoya-shi, Aichi 464-8601 (JP)
(72) Inventor: TANABE Shigeyuki, Saitama City, Saitama 331-0823 (JP); ASO Shinobu, Saitama City, Saitama 331-0823 (JP); SADAKATA Kazuki, Saitama City, Saitama 331-0823 (JP); NAGANO Hosei, Nagoya-shi, Aichi 464-8601 (JP); WATANABE Noriyuki, Nagoya-shi, Aichi 464-8601 (JP); MIZUTANI Takuji, Nagoya-shi, Aichi 464-8601 (JP)
(74) Representative: Strehl Schübel-Hopf & Partner
(86) International application number: PCT/JP2022/007759
(87) International publication number: WO 2022/254828

(57) **Abstract**

The present disclosure provides a method for manufacturing a heat exchanger including an evaporating body configured to absorb heat from outside and evaporate a liquid-phase working fluid into a gas phase while moving the working fluid by capillary forces. The method includes steps of: forming a recess in a plate surface of a first plate member, the first plate member being plate-shaped; applying a powder-containing material to a predetermined region in the recess; solidifying the material applied to the predetermined region to form the evaporating body; and covering the recess having the evaporating body formed thereon with a second plate member, the second plate member being plate-shaped, and securing the first plate member to the second plate member.

## Description

### Technical Field

The present invention relates to a manufacturing method and a heat exchanger.

### Background Art

Patent Document 1 discloses a loop heat pipe including an evaporator, a condenser, a liquid return pipe, and a wick that is located inside the evaporator and generates capillary forces in order to efficiently cool heating elements regardless of an installation angle.

### Citation List

### Patent Literature

Patent Document 1: Japanese Patent Application Laid-Open Publication No. 2008-215702

### Summary of Invention

### Technical Problem

Recent miniaturization and increased performance of devices, such as electronic devices, has led to an increased heat density of heating elements provided in the devices. In addition, a trend toward thinner-profile devices, for example, has been accompanied by the need for a heat exchanger that can remove heat flux from heating elements while having a reduced thickness dimension.

It is an object of the present disclosure to provide a method for manufacturing a heat exchanger and the like with a reduced thickness dimension.

### Solution to Problem

According to certain embodiments of the present disclosure, there is provided a method for manufacturing a heat exchanger including an evaporating body configured to absorb heat from outside and evaporate a liquid-phase working fluid into a gas phase while moving the working fluid by capillary forces. The method includes steps of: forming a recess in a plate surface of a first plate member, the first plate member being plate-shaped; applying a powder-containing material to a predetermined region in the recess; solidifying the material applied to the predetermined region to form the evaporating body; and covering the recess having the evaporating body formed thereon with a second plate member, the second plate member being plate-shaped, and securing the first plate member to the second plate member.

### Advantageous Effects of Invention

In accordance with the present disclosure, it is possible to manufacture a heat exchanger and the like with a reduced thickness dimension.

### Brief Description of Drawings

FIG. 1 illustrates a schematic configuration of a loop heat pipe in accordance with an exemplary embodiment.
FIGS. 2 is an exploded perspective view of the loop heat pipe.
FIGS. 3(a) and 3(b) illustrate a detailed configuration of a first side plate and a second side plate.
FIGS. 4(a) and 4(b) illustrate a configuration around a wick.
FIG. 5 illustrates a schematic configuration of a mask.
FIGS. 6(a) through 6(c) illustrate processes of manufacturing the loop heat pipe.
FIGS. 7(d) through 7(f) illustrate processes of manufacturing the loop heat pipe.
FIGS. 8(a) through 8(d) illustrate a first variation.
FIGS. 9(a) through 9(e) illustrate a second variation.
FIGS. 10(a) through 10(e) illustrate a third variation.
FIGS. 11(a) and 11(b) illustrate devices with the loop heat pipe.
FIG. 12 illustrates a variation of the loop heat pipe.

### Description of Embodiments

Exemplary embodiments will now be described with reference to the drawings.

### First Embodiment

### Schematic Configuration of Loop Heat Pipe 100

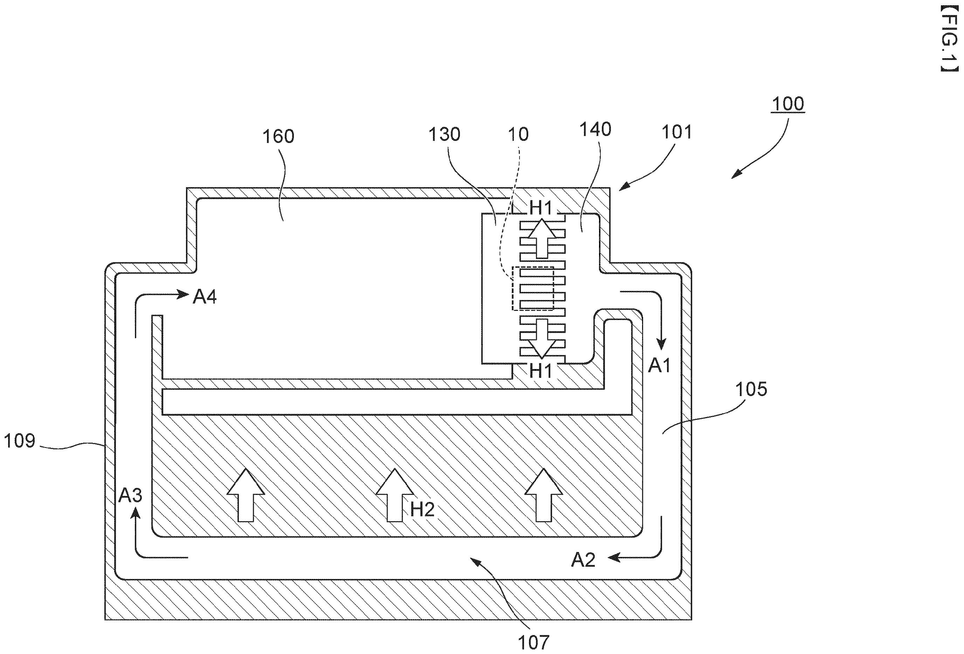

FIG. 1 illustrates a schematic configuration of a loop heat pipe 100 in accordance with an exemplary embodiment.

Referring initially to FIG. 1, a configuration of the loop heat pipe 100 in accordance with an exemplary embodiment will be described. The loop heat pipe 100 of the present embodiment is a heat exchanger that is configured to circulate a working fluid therein to cool a heating element 10, such as a central processing unit (CPU) in an electronic device, without power supply from outside.

More specifically, the loop heat pipe 100 includes an evaporator 101 configured to evaporate the working fluid to cool the heating element 10 using the latent heat of vaporization of the working fluid, and a condenser 107 configured to dissipate the heat of the working fluid vaporized in the evaporator 101 to liquefy it.

The loop heat pipe 100 further includes a vapor line 105 configured to deliver the working fluid vaporized in the evaporator 101 to the condenser 107, and a liquid line 109 configured to deliver the working fluid liquefied in the condenser 107 to the evaporator 101. The loop heat pipe 100 is filled with the working fluid that changes between liquid and vapor phases. For example, the working fluid may be water, alcohol, ammonia, etc.

### Operation of Loop Heat Pipe 100

Referring to FIG. 1, the operation of the loop heat pipe 100 will now be described.

Heat generated in the heating element 10 is transferred to the evaporator 101 (see arrows H1). The working fluid having absorbed the heat in the evaporator 101 is vaporized and delivered through the vapor line 105 (see arrow A1) to the condenser 107 (see arrow A2). The working fluid delivered to the condenser 107 dissipates its heat (see arrows H2) and liquefies. The liquefied working fluid is then delivered through the liquid line 109 (see arrow A3) back to the evaporator 101 (see arrow A4). As such, the loop heat pipe 100 is a powerless fluid device and also a two-phase heat transport device driven by the capillary force of the fluid.

### Detailed Configuration of Loop Heat Pipe 100

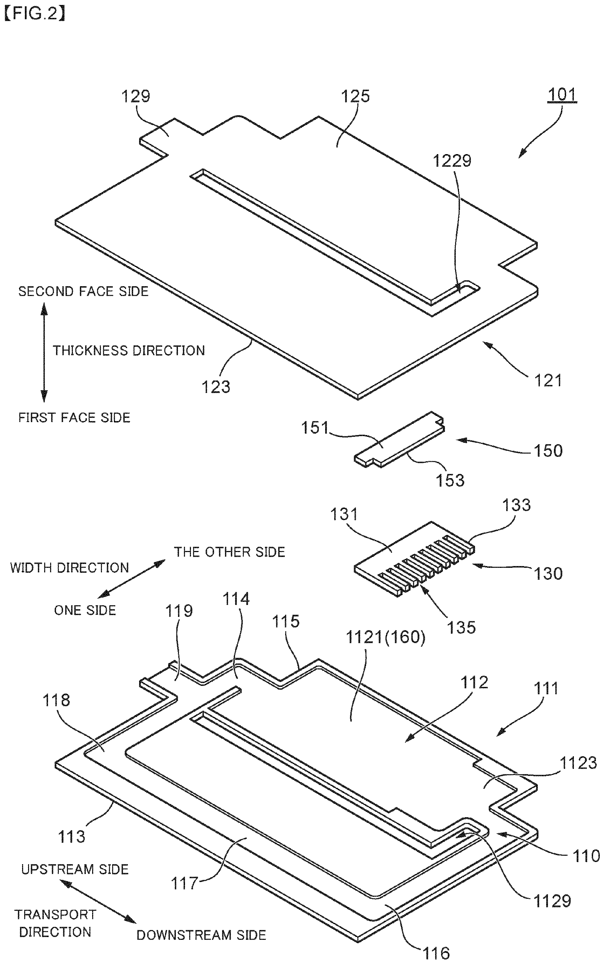

FIG. 2 is an exploded perspective view of the loop heat pipe 100.

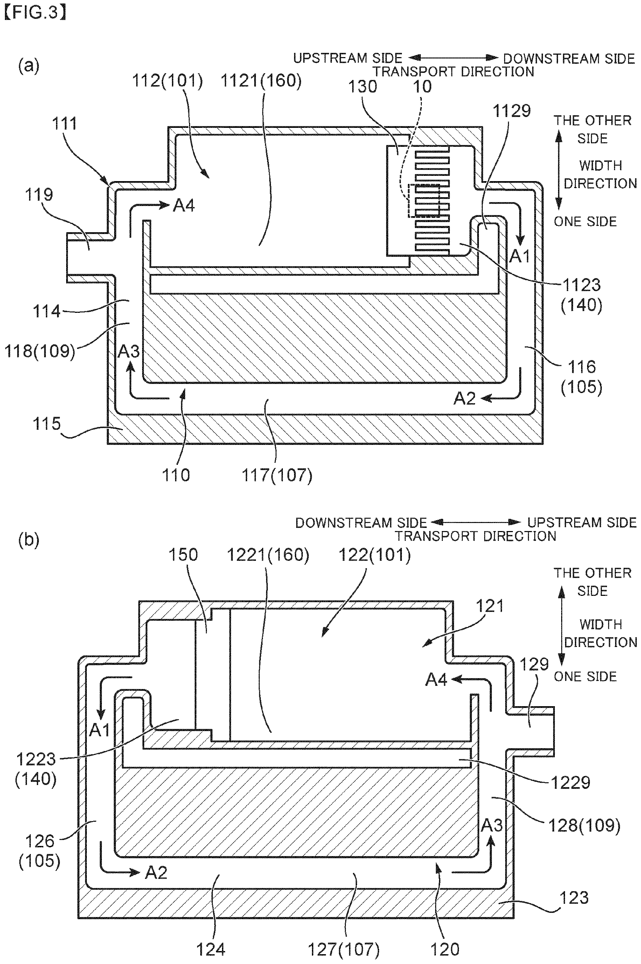

FIGS. 3(a) and 3(b) illustrate a detailed configuration of a first side plate 111 and a second side plate 121.

Referring next to FIGS. 2 through 3(b), a detailed configuration of the loop heat pipe 100 in accordance with the present embodiment will be described.

As shown in FIG. 2, the loop heat pipe 100 in accordance with the present embodiment has a generally planar shape. The loop heat pipe 100 includes generally planar first and second side plates 111, 121, and generally planar wick 130 and bonding member 150 disposed between the first and second side plates 111, 121. In other words, the loop heat pipe 100 is configured with the first and second side plates 111, 121 and the wick 130 and the bonding member 150 sandwiched therebetween.

The first side plate 111 includes first outer and inner surfaces 113, 115 of a generally rectangular shape in front view. The first side plate 111 further includes a first through-hole 1129 formed through opposite plate surfaces. The second side plate 121 includes second inner and outer surfaces 123, 125 of a generally rectangular shape in front view. The second side plate 121 further includes a second through-hole 1229 formed through opposite plate surfaces. The first and second side plates 111, 121 are made of a metal material such as copper. The wick 130 and the bonding member 150 are disposed between the first inner surface 115 of the first side plate 111 and the second inner surface 123 of the second side plate 121.

The loop heat pipe 100 can diffuse heat using the first and second side plates 111, 121, i.e., its enclosure. The loop heat pipe 100 is of a generally planar shape with a thickness of, for example, less than or equal to 1 mm. The loop heat pipe 100 is also dimensioned to allow it to be installed in a smartphone, for example. Specifically, the loop heat pipe 100 as a whole is dimensioned with a length of less than or equal to 100 mm, a width of less than or equal to 60 mm, and a thickness of less than or equal to 0.3 mm, for example. To further illustrate, the loop heat pipe 100 is dimensioned with a thickness of less than or equal to 3%, more preferably less than or equal to 1%, of its planar dimension (e.g., length or width).

The thickness direction of the loop heat pipe 100, i.e., the vertical direction in FIG. 2, may be hereinafter referred to simply as the thickness direction. The lower side in the vertical direction in FIG. 2 may be referred to as the first face side, and the upper side in FIG. 2 may be referred to as the second face side. The direction in which the working fluid is transported in the wick 130, i.e., the direction extending between the upper left and the lower right in FIG. 2, may be referred to simply as the transport direction. The upper left side in FIG. 2 may be referred to as the upstream side, and the lower right side may be referred to as the downstream side. The direction perpendicular to the vertical and transport directions in FIG. 2 may be referred to as the width direction. The left frontward side in the width direction in the page of FIG. 2 may be referred to as one side, and the right rearward side in the width direction in the page of FIG. 2 may be referred to as the other side.

As shown in FIG. 3(a), the first side plate 111 includes a first recess 110 formed on the first inner surface 115. The first recess 110 is an annular region formed around the periphery of the first through-hole 1129 in the first inner surface 115. To further illustrate, the first recess 110 includes a first evaporator region 112, a first vapor line region 116, a first condenser region 117, a first liquid line region 118, and a first opening region 119, which are annularly continuous with each other.

As shown in FIG. 3(b), the second side plate 121 includes a second recess 120 formed on the second inner surface 123. The second recess 120 is an annular region formed around the periphery of the second through-hole 1229 in the second inner surface 123. The second recess 120 has a mirrored shape to the first recess 110. In other words, the first and second recesses 110, 120 are in a mirror symmetry relationship. To further illustrate, the second recess 120 includes a second evaporator region 122, a second vapor line region 126, a second condenser region 127, a second liquid line region 128, and a second opening region 129, which are annularly continuous with each other.

When the first inner surface 115 of the first side plate 111 and the second inner surface 123 of the second side plate 121 are positioned face-to-face, the first and second recesses 110, 120 confront each other. In this arrangement, the first and second evaporator regions 112, 122 form the evaporator 101. Likewise, the first and second vapor line regions 116, 126 form the vapor line 105. The first and second condenser regions 117, 127 form the condenser 107. The first and second liquid line regions 118, 128 form the liquid line 109.

The first and second opening regions 119, 129 form an opening that allows for injection of the working fluid into the first and second recesses 110, 120 from outside after bonding the first inner surface 115 of the first side plate 111 and the second inner surface 123 of the second side plate 121. To further illustrate, the opening formed by the first and second opening regions 119, 129 is closed after the injection of the working fluid.

The first and second evaporator regions 112, 122, which form the evaporator 101, will now be described.

First, the first evaporator region 112 is of a generally rectangular shape in plan view. The first evaporator region 112 includes a first wide region 1121 defining a space continuous with the first liquid line region 118, and a first narrow region 1123 defining a space downstream of the first wide region 1121 and continuous with the first vapor line region 116. The first wide region 1121 and the first narrow region 1123 are arranged in line with each other in the transport direction. The first wide region 1121 is dimensioned larger than the first narrow region 1123 in the width direction.

Similarly, the second evaporator region 122 is of a generally rectangular shape in plan view. The second evaporator region 122 includes a second wide region 1221 defining a space continuous with the second liquid line region 128, and a second narrow region 1223 defining a space downstream of the second wide region 1221 and continuous with the second vapor line region 126. The second wide region 1221 and the second narrow region 1223 are arranged in line with each other in the transport direction. The second wide region 1221 is dimensioned larger than the second narrow region 1223 in the width direction.

As will be detailed below, the wick 130 is disposed inside the first and second evaporator regions 112, 122. In the interiors of the first and second evaporator regions 112, 122, a space that is closer to the liquid line 109 than the wick 130 is serves as a liquid reservoir 160, in which the liquid-phase working fluid is contained. In the illustrated example, the first and second wide regions 1121, 1221 define the liquid reservoir 160. Also, in the interiors of the first and second narrow regions 1123, 1223, a space that is closer to the vapor line 105 than the wick 130 is serves as a vapor space 140, through which the gas-phase working fluid passes.

### Configuration around Wick 130

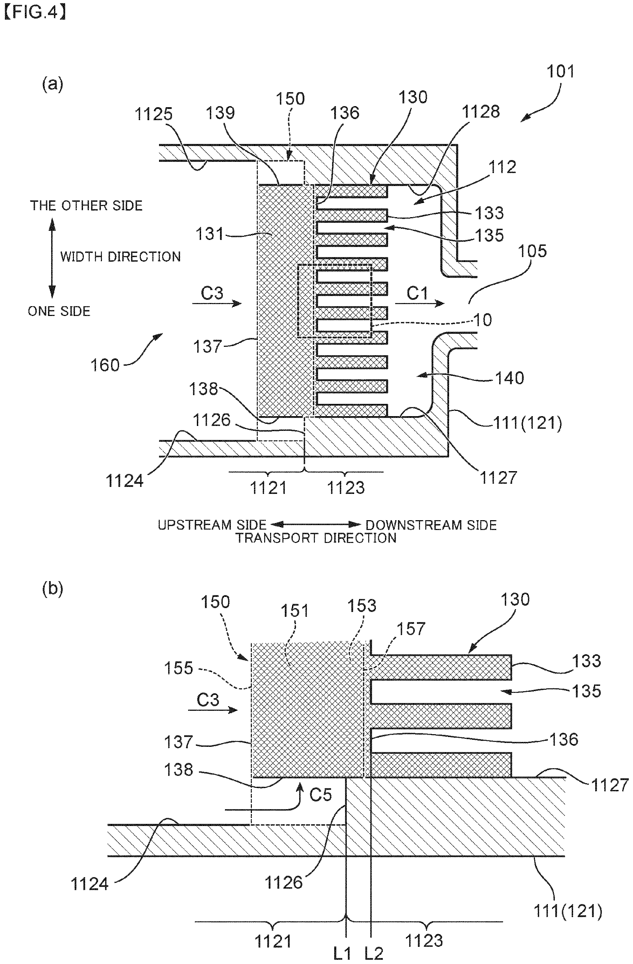

FIGS. 4(a) and 4(b) illustrate a configuration around the wick 130.

Referring next to FIGS. 4(a) and 4(b), a configuration of the wick 130 and its surrounding components will be described.

The wick 130 is made of a porous body, such as a porous metal of copper or the like. The wick 130 generates capillary forces in the working fluid, causing the working fluid to move. The effective pore size of the wick 130 is 0.1 to 50 µm. The porosity of the wick 130 is 25 to 80%. Any method may be used to measure the effective pore size and porosity. For example, the effective pore size and porosity may be measured based on apparent density measurement by water immersion, pore size distribution measurement by mercury porosimetry, or pore observation by X-ray CT.

To further illustrate, the wick 130 is dimensioned with, for example, a length of 10 mm to 300 mm in the width direction, a length of 3 mm to 100 mm in the transport direction, and a thickness of 0.01 mm to 1 mm, more preferably 0.1 mm to 0.5 mm. In addition, the wick 130 is dimensioned such that its thickness is, for example, about 0.01 to 1%, more preferably 0.1 to 0.5%, of the length in the width direction, i.e., its longitudinal length. Note that the heating element 10 (see FIG. 1) is, for example, 10 mm wide and 10 mm long. The wick 130 is dimensioned with a larger width and length than the heating element 10.

As shown in FIG. 4(a), the wick 130 includes a generally rectangular wick base portion 131 having a longitudinal direction extending along the width direction, and wick prongs 133 projecting downstream in the transport direction from the wick base portion 131. In the illustrated example, a plurality of wick prongs 133 are provided at predetermined intervals in the width direction. In other words, the wick 130 includes a plurality of slits 135 located downstream in the transport direction and extending along the transport direction. The upstream end in the transport direction of the slit 135 is referred to as a slit bottom 136. The wick prong 133 is 0.5 mm to 2.0 mm long in the width direction and 10 mm to 20 mm long in the transport direction. The slit 135 is 0.5 mm to 2.0 mm long in the width direction, for example. To further illustrate, the slit 135 is longer in the width direction (wider) than the wick prong 133. The slit 135 may have the same length as or a different length than the wick prong 133 in the width direction. Besides the illustrated example, the distal end of the wick prong 133 and the slit bottom 136 may be rounded (curved).

The wick 130 is generally comb-shaped (rake-shaped). The slits 135 formed in the wick 130 serve as vapor grooves, or so-called grooves, that facilitate the flow of the working fluid vaporized in the wick 130 toward the vapor line 105. To further illustrate, in the illustrated example, the wick prongs 133 and the slits 135 are alternately arranged in the same plane, which allows the wick 130, the first side plate 111, and the second side plate 121 to be thinner while maintaining the mechanical strength. In addition, providing the wick prongs 133 and the slits 135 in the same plane improves the flexibility in disposing the heating element 10 (FIG. 1), which is the heat source. Specifically, the heating element 10 may be provided on either or both of the first outer surface 113 of the first side plate 111 and the second outer surface 125 of the second side plate 121.

The wick 130 is disposed over both of a portion of the first wide region 1121 and a portion of the first narrow region 1123 of the first side plate 111 in the transport direction. To further illustrate, the wick 130 is disposed to develop (project) from the first narrow region 1123 toward the first wide region 1121.

The wick 130 is sandwiched between a narrow first and second side faces 1127, 1128 in the first narrow region 1123. To further illustrate, a wick first side face 138, which is a side face of the wick 130 along the transport direction, is bonded to the narrow first side face 1127 of the first side plate 111. Also, a wick second side face 139 is bonded to the narrow second side face 1128 of the first side plate 111. Even if the material of the wick 130 shrinks during the formation of the wick 130 by sintering as described below, the wick 130 is prevented from being spaced from the narrow first and second side faces 1127, 1128.

A wick upstream end face 137 is located within the first wide region 1121. Accordingly, the wick first and second side faces 138, 139 are exposed in the first wide region 1121. To further illustrate, the wick first and second side faces 138, 139 are spaced from wide first and second side faces 1124, 1125, respectively, of the first side plate 111. This permits the liquid-phase working fluid to flow into the wick 130 through the wick first and second side faces 138, 139 (see arrow C5 in FIG. 4(b)). This increases the area where the wick 130 is in contact with the liquid-phase working fluid, improving the wetting of the wick 130.

The wick 130 is disposed sandwiched between the first and second side plates 111, 121 as described above. The wick 130 also provides a partition between the vapor space 140 and the liquid reservoir 160. Here, if a gap is created between the first side plate 111 and the wick 130 or between the second side plate 121 and the wick 130, the liquid-phase working fluid may flow (leak) into the vapor space 140 or the gas-phase working fluid may flow into the liquid reservoir 160. Such inflow would reduce the heat exchange rate of the loop heat pipe 100.

Hence, in the present embodiment, the wick 130 is formed on the first side plate 111 by applying a material for use as the wick 130 to the first inner surface 115 of the first side plate 111 (described below). This prevents a gap from being created between the wick 130 and the first inner surface 115 of the first side plate 111. Additionally, in the present embodiment, a bonding member 150 is disposed over the wick 130. This prevents a gap from being created between the wick 130 and the second inner surface 123 of the second side plate 121.

As shown in FIG. 4(b), the bonding member 150 includes a generally rectangular bonding member base portion 151 having a longitudinal direction extending along the width direction, and a bonding member narrow portion 153 projecting downstream in the transport direction from the bonding member base portion 151. The bonding member narrow portion 153 is of a generally rectangular shape having a longitudinal direction extending along the width direction, and is dimensioned narrower than the bonding member base portion 151 in the width direction. The bonding member 150 is a plate-shaped metal member made of bronze or the like.

The bonding member 150 is located to cover the wick base portion 131 of the wick 130. To further illustrate, the bonding member 150 is disposed over both a portion of the first wide region 1121 and a portion of the first narrow region 1123 in the transport direction. The bonding member 150 is formed sandwiched between the narrow first and second side faces 1127, 1128 in the width direction. The bonding member 150 is also formed sandwiched between the wide first and second side faces 1124, 1125 in the width direction. A bonding member upstream end face 155 as shown is aligned with the wick upstream end face 137 in the transport direction. Note that the bonding member 150 is not limited to being configured as shown in the figures, provided that both ends thereof are in contact with the narrow first and second side faces 1127, 1128. For example, the bonding member 150 need not be in contact with the wide first and second side faces 1124, 1125 in the width direction. Also, the bonding member 150 need not be disposed over both a portion of the first wide region 1121 and a portion of the first narrow region 1123 in the transport direction. The bonding member upstream end face 155 as shown need not be aligned with the wick upstream end face 137 in the transport direction.

Referring now to FIG. 4(b), the position in the transport direction of a bonding member downstream end face 157, which is a downstream end face of the bonding member 150 in the transport direction, will be described. The position of the bonding member downstream end face 157 in the transport direction is located between a virtual line L1, which extends along a step surface 1126 connecting the wide first side face 1124 and the narrow first side face 1127, and a virtual line L2, which extends along the slit bottoms 136. If the bonding member downstream end face 157 is located upstream of the virtual line L1 in the transport direction, leakage of the working fluid may occur. If the bonding member downstream end face 157 is located downstream of the virtual line L2 in the transport direction, the function of the slits 135 may degrade.

### Operation of Evaporator 101

Referring next to FIG. 4(a), the operation of the evaporator 101 will be described.

First, the liquid-phase working fluid contained in the liquid reservoir 160 flows toward the wick 130 (see arrow C3) and permeates the wick 130. The liquid-phase working fluid is then heated and vaporized by the heat of the heating element 10 as it moves through the wick 130 due to capillary forces of the wick 130.

The vaporized working fluid passes through the slits 135 and other portions toward the vapor line 105 (see arrow C1) and then flows through and exits the vapor line 105 for delivery to the condenser 107 (see FIG. 1). The liquefied working fluid in the condenser 107 (see FIG. 1) then flows into the evaporator 101 and goes through the liquid reservoir 160 to permeate the wick 130 again.

As such, the above cycle is repeated without interruption of the flow of the working fluid at the wick 130. The heat generated in the heating element 10 is thus transported from the evaporator 101 to the condenser 107 (see FIG. 1).

### Processes of Forming First and Second Side Plates 111, 121

As described above, the first and second side plates 111, 121 are formed of a planar member made of copper or other metal material, which is processed to form the first and second recesses 110, 120. In the illustrate example, a 0.15 mm-thick copper flat plate is etched to form the first and second recesses 110, 120. The first and second recesses 110, 120 are 0.1 mm in depth. In other words, the regions in the first and second side plates 111, 121 where the first and second recesses 110, 120 are formed are 0.05 mm thick. To further illustrate, etching is used to remove at least 50% of the thickness of the first and second side plates 111, 121. A through etching, or outer copper plate etching, is performed around the outer shape of the first and second side plates 111, 121 to allow the first and second side plates 111, 121 to be taken out. In the illustrated example, a through etching is also performed to form the first through-hole 1129 in the first side plate 111 and the second through-hole 1229 in the second side plate 121.

### Processes of Forming Wick 130 and Bonding Member 150

Referring next to FIGS. 4(a) and 4(b), processes of forming the wick 130 and the bonding member 150 will be described.

In the present embodiment, the wick 130 and the bonding member 150 are formed on the first side plate 111 and the second side plate 121, respectively. After overlapping the first side plate 111 having the wick 130 formed thereon and the second side plate 121 having the bonding member 150 formed thereon, the wick 130 and the bonding member 150 are secured to each other.

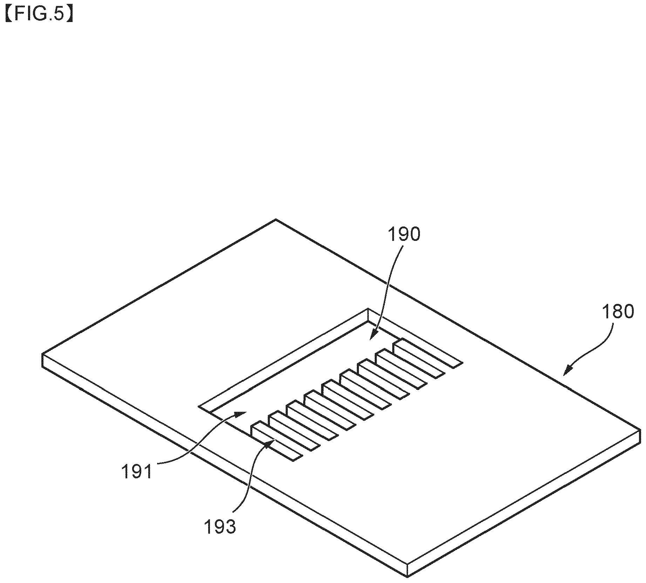

The wick 130 as shown is formed on the first side plate 111 by applying a material of the wick 130 to the first side plate 111. To further illustrate, the wick 130 is formed by applying a metal paste containing pure copper powder to predetermined regions in the first wide region 1121 and the first narrow region 1123 of the first side plate 111. A mask 180 (see FIG. 5 below) is used to apply the wick 130, as described in detail below.

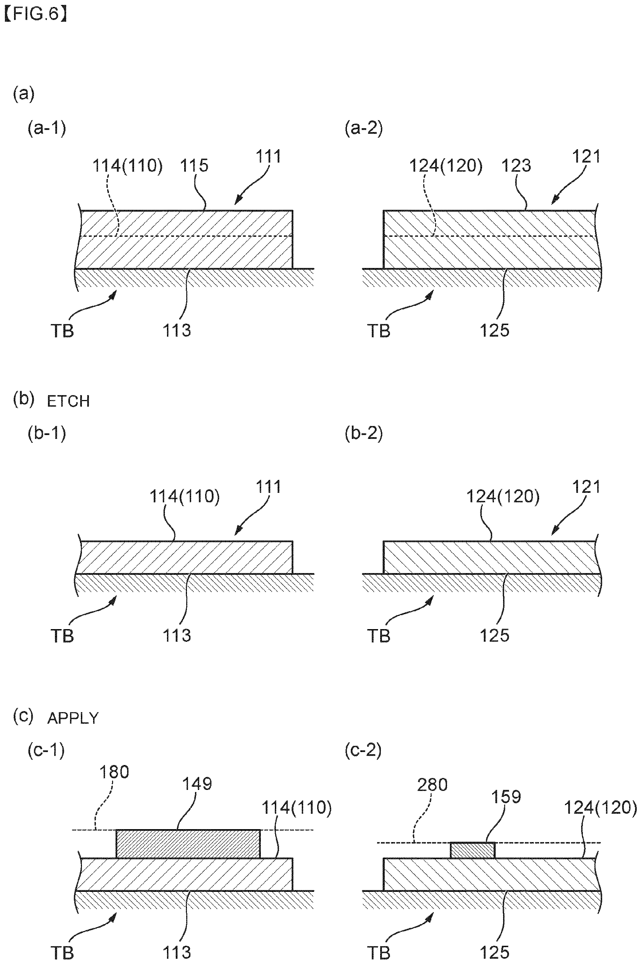

The bonding member 150 as shown is formed on the second side plate 121 by applying a material of the bonding member 150 to the second side plate 121. To further illustrate, the bonding member 150 is formed by applying a metal paste containing bronze powder to predetermined regions in the second wide region 1221 and the second narrow region 1223 of the second side plate 121. The bonding member 150 is applied using any well-known masking technique, such as covering the periphery of the regions where the bonding member 150 is formed with so-called masking tape 280 (see FIG. 6(c-2) below). In the illustrated example, the bonding member 150 is 4 mm long in the transport direction. To further illustrate, the bonding member base portion 151 is 3 mm long in the transport direction, and the bonding member narrow portion 153 is 1 mm long in the transport direction.

### Mask 180

FIG. 5 illustrates a schematic configuration of the mask 180.

For example, the mask 180 is a 0.3 mm-thick planar metal member. The mask 180 includes a wick-shaped opening 190 as a through-hole. The wick-shaped opening 190 includes a wick base portion region 191 defining the region where the wick base portion 131 is formed and a wick prong region 193 defining the region where the wick prongs 133 are formed. The wick base portion region 191 is a generally rectangular portion having a longitudinal direction extending along the width direction. The wick prong region 193 is a portion projecting downstream in the transport direction from the wick base portion region 191.

The mask 180 is positioned in alignment with the first side plate 111 having the first recess 110 formed therein. Then, the metal paste containing pure copper powder is introduced from above the mask 180 into the wick-shaped opening 190 and applied by, for example, scraping off excess metal paste with a rubber blade (so-called squeegee) or the like. This results in the material of the wick 130 being disposed in the first recess 110 at a predetermined thickness (e.g., 0.3 mm). This applied material of the wick 130 is solidified by sintering or other means to form the wick 130 in the first recess 110. The use of the mask 180 can, for example, simplify the process of forming the wick 130 having the wick prongs 133.

### Processes of Manufacturing Loop Heat Pipe 100

FIGS. 6(a) through 7(f) illustrate processes of manufacturing the loop heat pipe 100.

Referring next to FIGS. 6(a) through 7(f), processes of manufacturing the loop heat pipe 100 of the present embodiment will be described. Although not shown in the figures, the first side plate 111 has already been masked except for the regions where the first recess 110 is to be formed, and where the above through etching is to be performed (i.e., the periphery around its outer profile, as well as the first through-hole 1129). Similarly, the second side plate 121 has already been masked except for the regions where the second recess 120 is to be formed, and where the above through etching is to be performed (i.e., the periphery around its outer profile, as well as the second through-hole 1229).

First, as shown in FIG. 6(a), the first and second side plates 111, 121 are each placed on a table TB. Then, as shown in FIG. 6(b), the first and second side plates 111, 121 are etched to form the first and second recesses 110, 120. Then, as shown in FIG. 6(c), metal paste is applied to the first and second recesses 110, 120. Specifically, as shown in FIG. 6(c-1), the mask 180 is placed on a first bottom face 114 of the first recess 110, and a first metal paste 149 for use as the wick 130 is applied. As shown in FIG. 6(c-2), masking tape 280 is placed on a second bottom face 124 of the second recess 120, and a second metal paste 159 for use as the bonding member 150 is applied.

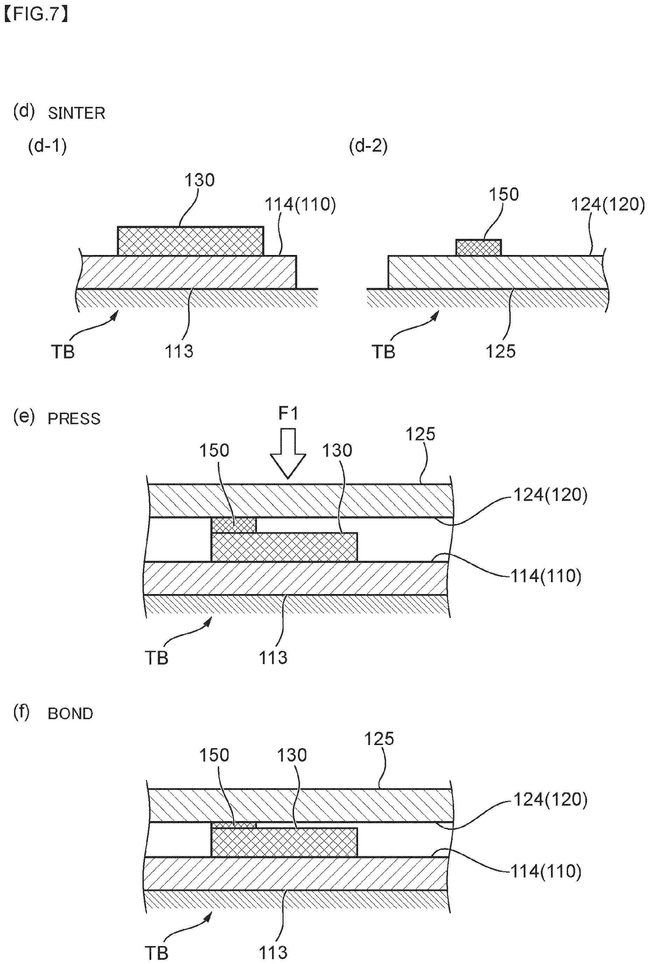

As shown in FIG. 7(d), the first and second metal pastes 149, 159 are heated under their respective conditions (with details to follow). Thus, as shown in FIG. 7(d-1), the first metal paste 149 is sintered, resulting in the wick 130. This formed wick 130 is secured to the first bottom face 114. Similarly, as shown in FIG. 7(d-2), the second metal paste 159 is sintered, resulting in the bonding member 150. This formed bonding member 150 is secured to the second bottom face 124.

Then, as shown in FIG. 7(e), solder is placed around the first and second recesses 110, 120 of the first and second side plates 111, 121. In other words, solder is placed on the raised portions of the first and second side plates 111, 121. The amount of solder placed on the raised portions is defined such that the solder, when molten, does not flow into the first and second recesses 110, 120. Also, the position of solder placed on the raised portions is defined such that the solder, when molten, does not flow into the first and second recesses 110, 120. Then, the first and second side plates 111, 121 with the solder placed thereon are stacked. This results in the wick 130 and the bonding member 150 confronting and abutting each other. The first and second side plates 111, 121 may then be pressed (see arrow F1 in the figure) to adjust (reduce) the thickness of the wick 130.

As shown in FIG. 7(f), the wick 130 and the bonding member 150 are bonded by heating the first and second side plates 111, 121. Then, after leaving the furnace, treatment is applied to enhance sealing. For example, any well-known technique may be employed to further ensure sealing, such as placing solder on side faces (e.g., 0.3 mm thick) of the first and second side plates 111, 121, or applying and curing a sealant such as silicone- or UV-curing resin.

In the illustrated example, as shown in FIG. 7(d), the first and second side plates 111, 121 are supported on the flat table TB when they are heated to sinter the first and second metal pastes 149, 159. This may reduce deformation of the first and second side plates 111, 121 due to heating, compared to when the first and second side plates 111, 121 are not supported on the table TB.

### First and Second Metal Pastes 149, 159

For example, the first and second metal pastes 149, 159 may be prepared as follows. The first metal paste 149 for use as the wick 130 can be prepared by mixing pure copper powder with a grain size of 45 µm or less into a binder solution. The second metal paste 159 for use as the bonding member 150 can be prepared by mixing tin-50 wt.% bronze powder with a grain size of 45 µm or less into a binder solution. The binder solution consists of a binder component and an organic solvent. The binder component can be selected from, but is not limited to, acrylic, butyral, and cellulose-based components. The organic solvent can be selected from, but is not limited to, acetone, benzene, isopropanol, methanol, ethanol, toluene, n-butanol, xylene, ethylene glycol, ethyl acetate, terpineol, butyl acetate, tetrahydrofuran (THF), carbon tetrachloride, methyl ethyl ketone (MEK), chloroform, methyl isobutyl ketone (MIBK), n-hexane, methanol, and cyclohexane.

The first and second metal pastes 149, 159 are debinded and sintered in a mesh belt sintering furnace. Here, the first and second metal pastes 149, 159 placed (applied) on the first and second side plates 111, 121 are sintered under the following conditions, for example. For the first metal paste 149, the debinding temperature may be 600°C, the sintering temperature may be 920°C, the hold time may be 30 minutes, and the atmosphere gas may be 80% nitrogen and 20% hydrogen. For the second metal paste 159, the debinding temperature may be 600°C, the sintering temperature may be 600°C, the hold time may be 30 minutes, and the atmosphere gas may be 80% nitrogen and 20% hydrogen.

### Securing of First and Second Side Plates 111, 121

As shown in FIG. 7(e), the first and second side plates 111, 121 are secured, for example, under the following conditions. First, flux that activates solder is applied to the first side plate 111, and then solder (e.g., lead solder containing 60% tin and 40% lead) is placed on top of it, followed by applying flux onto the solder. Then, with the first and second side plates 111, 121 overlapped, the portions where the wick 130 and the bonding member 150 are formed are pressed from outside (see arrow F1 in the figure) to adjust the combined thickness of the wick 130 and the bonding member 150 to equal the channel height.

Next, the first and second side plates 111, 121 are secured (temporarily fastened) by spot welding or other means. Then, solder bonding and bonding of the wick 130 and the bonding member 150 are carried out in a mesh belt sintering furnace. This bonding is carried out, for example, under the following heat treatment conditions. That is, the temperature may be 660°C, the hold time may be 30 minutes, and the atmosphere gas may be 80% nitrogen and 20% hydrogen. Additionally, the first and second side plates 111, 121 are sandwiched between ceramic plates, and the heat treatment is applied with a weight load of 1 kg.

The loop heat pipe 100 formed under the above conditions was leak tested, which showed that there were no problems with degassing. In addition, heat load testing on the produced loop heat pipe 100 proved that it could operate at 4.5W to 10W.

### Bonding with Bonding Member 150

As described above, the wick 130 and the second side plate 121 are secured to each other via the bonding member 150. This securing with the bonding member 150 will be described.

First, as shown in FIG. 7(f), the wick 130 formed by sintering the first metal paste 149 is bonded at its first face side in the thickness direction to the first side plate 111. Additionally, the wick 130 is required to be bonded (sealed) at its second face side in the thickness direction to the second side plate 121. If, unlike the present embodiment, solder (e.g., 500°C) is used instead of the bonding member 150 to bond the wick 130 to the second side plate 121, the solder would be absorbed by the wick 130, with the consequent risk of degrading the function of the wick 130. Also if, unlike the present embodiment, brazing (e.g., 800°C) or diffusion bonding (e.g., 1000°C) is used to bond the wick 130 to the second side plate 121, the channel for the working fluid could be blocked due to deflection or other deformation of the first and second side plates 111, 121.

Hence, in the illustrated example, the bonding member 150 is used for bonding. The bonding member 150 is made of a material (e.g., bronze) that has a lower melting point than that of the wick 130 (e.g., pure copper). The bonding member 150 may be made of any material that is easily alloyed with or compatible with the wick 130 and the second side plate 121. For example, when the wick 130 is made of pure copper, brass or other material may be used as the bonding member 150. The material of the bonding member 150 can be viewed as one that has the same composition (e.g., copper) as the wick 130 and the second side plate 121. The material of the bonding member 150 can also be viewed as one that has a lower melting point than the alloy of the second side plate 121. In the above example, the sintering of the first metal paste 149, or the first heating, is carried out at 920°C. The bonding of the wick 130 to the bonding member 150, or the second heating, is carried out at 660°C, which is lower than the first heating temperature. This reduces possible changes in structure of the wick 130 due to the second heating.

As described above, the bonding of the wick 130 to the bonding member 150 allows the wick 130 to be secured to both the first and second side plates 111, 121. The secured wick 130 and bonding member 150 serve as a pressure bulkhead between the vapor space 140 and the liquid reservoir 160.

### First Variation

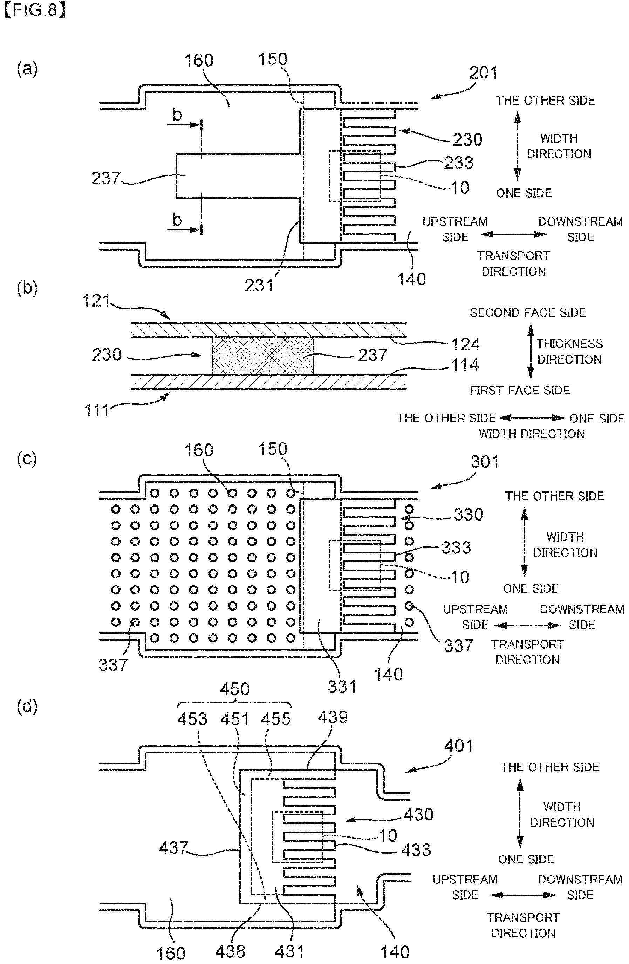

FIGS. 8(a) through 8(d) illustrate a first variation.

Referring to FIGS. 8(a) through 8(d), a first variation will be described. In the following description, the same reference numerals are used to refer to the same features as those in the above embodiment, and their detailed description may be omitted.

In the above embodiment, the wick 130 has been described as having a generally comb-like shape. However, this is not limiting, and the wick 130 may have any other structure that allows it to be installed in the same plane. For example, a wick 230 may be formed as shown in FIG. 8(a). The wick 230 includes a wick base portion 231 having a longitudinal direction extending along the width direction, a plurality of wick prongs 233 projecting downstream in the transport direction from the wick base portion 231, and a wick protrusion 237 projecting upstream in the transport direction from the wick base portion 231. The wick 230 is formed by application of a material for use as the wick 230, as in the above embodiment.

Here, when the liquid reservoir 160 contains a small amount of working fluid, the working fluid may be unevenly distributed in the liquid reservoir 160. Such uneven distribution of the working fluid may inhibit it from being supplied to the wick 230, with the consequent risk of degrading the operating performance of the wick 230. Hence, as in the wick 230, the wick protrusion 237 is formed protruding into the interior of the liquid reservoir 160. This may ensure a stable supply of the working fluid to the wick base portion 231 and the wick prongs 233 through the wick protrusion 237, even when the working fluid is unevenly distributed within the liquid reservoir 160.

The wick protrusion 237 can be viewed as another wick, or a secondary wick, for supplying the working fluid to the wick base portion 231 and other portions. The wick protrusion 237 may be of any material, shape (e.g., pillar or mesh form), etc. that can provide a structure having predetermined capillary forces. The wick protrusion 237 may be dimensioned such that flow pressure loss is not greater than a predetermined value.

Additionally, as shown in FIG. 8(b), the wick protrusion 237 is bonded at both ends in the thickness direction to the first bottom face 114 of the first side plate 111 and the second bottom face 124 of the second side plate 121. This may reduce or prevent deformation of the first and second side plates 111, 121. To further illustrate, the presence of the wick protrusion 237 may reduce or prevent bulging or sinking (denting) of the first and second side plates 111, 121 even when, for example, the first and second side plates 111, 121 are configured with a small thickness.

In one alternative configuration to reduce or prevent deformation of the first and second side plates 111, 121, a wick 330 may be configured as shown in FIG. 8(c). The wick 330 includes a wick base portion 331 having a longitudinal direction extending along the width direction, a plurality of wick prongs 333 projecting downstream in the transport direction from the wick base portion 331, and a plurality of wick remote portions 337 spaced from the wick base portion 331 and the wick prongs 333. The wick 330 is formed by application of a material for use as the wick 330, as in the above embodiment. Note that some or all of the wick remote portions 337 can be formed in the etching process of forming the first and second recesses 110, 120 as described above.

In the illustrated example, a plurality of wick remote portions 337 are formed in the liquid reservoir 160. Each wick remote portion 337 is bonded at both ends in the thickness direction to the first bottom face 114 of the first side plate 111 and the second bottom face 124 of the second side plate 121, which may reduce or prevent deformation of the first and second side plates 111, 121.

The wick remote portions 337 are not limited to being located in the liquid reservoir 160 as in the illustrated example, and may be provided in the vapor space 140 in addition to or instead of in the liquid reservoir 160. The wick remote portion 337 may also be provided in the vapor line 105, the condenser 107, and/or the liquid line 109, etc.

The wick remote portions 337 function to prevent channel blockage or constriction due to negative pressure. The wick remote portions 337 are dimensioned and mutually spaced so as not to obstruct the flow of the working fluid. Additionally, the manufacturing process may be simplified by forming the wick remote portions 337 using the same material and process as used for forming the wick base portion 331 and the wick prongs 333. Note that the wick base portion 331 and the wick prongs 333 may be made of different materials.

As shown in FIG. 8(d), a wick 430 may be disposed in the liquid reservoir 160. This wick 430 includes a wick base portion 431 having a longitudinal direction extending along the width direction, and a plurality of wick prongs 433 projecting downstream in the transport direction from the wick base portion 431. The wick base portion 431 and the wick prongs 433 are disposed in the liquid reservoir 160. This allows the wick 430 to receive a supply of the liquid-phase working fluid at the three faces of the wick 430, namely a wick upstream end face 437, a wick first side face 438, and a wick second side face 439. To further illustrate, the wick 430 can receive a stable supply of the working fluid even when the working fluid is unevenly distributed within the liquid reservoir 160.

A bonding member 450 is placed over the wick 430. The bonding member 450 is generally U-shaped. To further illustrate, the bonding member 450 includes an upstream portion 451 extending along the wick upstream end face 437, a first portion 453 extending along the wick first side face 438, and a second portion 455 extending along the wick second side face 439. The upstream portion 451, the first portion 453, and the second portion 455 reduce or prevent leakage of the working fluid in the region of the wick 430 in contact with the liquid reservoir 160.

### Second Variation

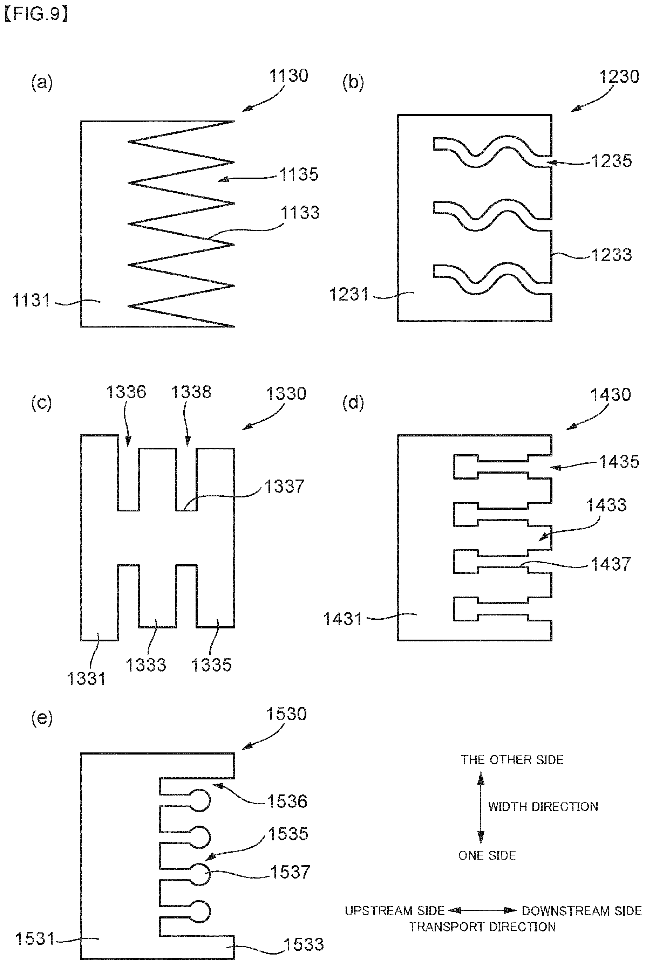

FIGS. 9(a) through 9(e) illustrate a second variation.

Referring to FIGS. 9(a) through 9(e), a second variation will be described.

In the above embodiment, the wick 130 has been described as being generally comb-shaped. However, this is not limiting.

For example, a wick 1130 may be formed as shown in FIG. 9(a). The wick 1130 includes a wick base portion 1131 having a longitudinal direction extending along the width direction, and a plurality of wick prongs 1133 projecting downstream in the transport direction from the wick base portion 1131. Each of the wick prongs 1133 has a width direction length that varies at different positions in the transport direction. Specifically, the wick prongs 1133 are dimensioned to be smaller in the width direction as one moves downstream in the transport direction. Also, slits 1135, which define gaps between the respective wick prongs 1133, are dimensioned to be larger in the width dimension as one moves downstream in the transport direction.

Alternatively, a wick 1230 may be formed as shown in FIG. 9(b). The wick 1230 includes a wick base portion 1231 having a longitudinal direction extending along the width direction, and a plurality of wick prongs 1233 projecting downstream in the transport direction from the wick base portion 1231. The wick prongs 1233 are curved in a generally S-shape fashion, or in other words, they are of a corrugated shape. Slits 1235 are also curved accordingly.

Still alternatively, a wick 1330 may be formed as shown in FIG. 9(c). The wick 1330 is configured to be spaced in the transport direction and connected at the center in the width direction. To further illustrate, the wick 1330 includes a plurality of wick base portions 1331, 1333, 1335 each having a longitudinal direction extending along the width direction, and a connecting portion 1337 that connects the wick base portions 1331, 1333, 1335 at the center in the width direction. Gaps 1336, 1338 created between the wick base portions 1331, 1333, 1335 serve as channels for the working fluid.

Still alternatively, a wick 1430 may be formed as shown in FIG. 9(d). The wick 1430 includes a wick base portion 1431 having a longitudinal direction extending along the width direction, and a plurality of wick prongs 1433 projecting downstream in the transport direction from the wick base portion 1431. Each of the wick prongs 1433 includes a wide portion 1437 projecting in the width direction from the center of the wick prong 1433 in the transport direction. Gaps 1435 between the respective wick prongs 1433 serve as channels for the working fluid.

Still alternatively, a wick 1530 may be formed as shown in FIG. 9(e). The wick 1530 includes a wick base portion 1531 having a longitudinal direction extending along the width direction, two wick prongs 1533 projecting downstream in the transport direction from both ends in the width direction of the wick base portion 1531, and protrusions 1535 projecting downstream in the transport direction from the wick base portion 1531. Each of the protrusions 1535 includes a wide portion 1537 that is located downstream in the transport direction and dimensioned larger in the width direction. In the illustrated example, the wide portion 1537 is generally circular in plan view. Gaps 1536 between the respective wick prongs 1533 and protrusions 1535 serve as channels for the working fluid.

### Third Variation

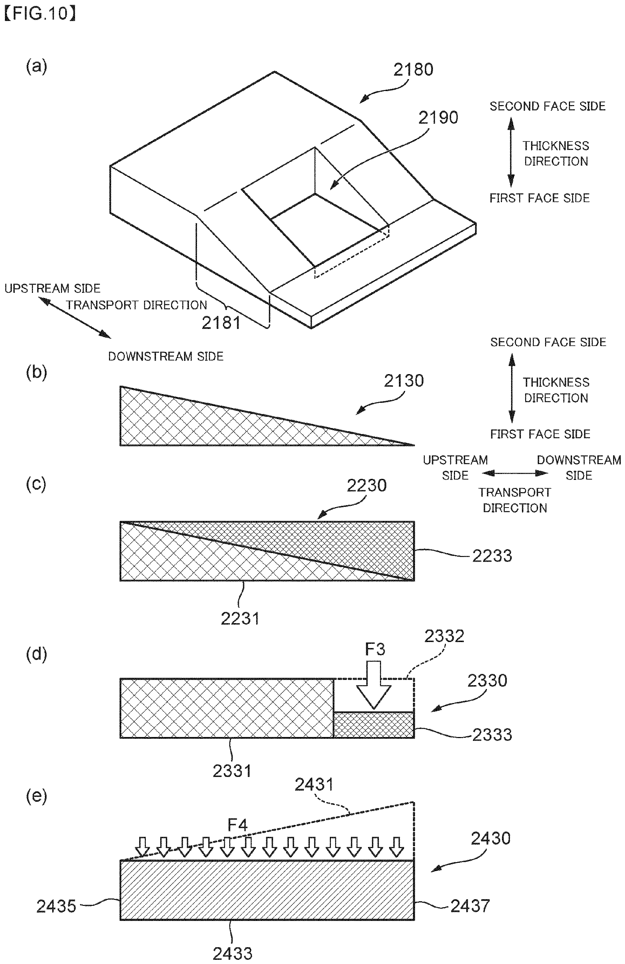

FIGS. 10(a) through 10(e) illustrate a third variation.

Referring to FIGS. 10(a) through 10(e), a third variation will be described.

In the above embodiment, the wick 130 has been described as being formed by applying it. Here, when the wick 130 is formed by applying it, the shape of the wick 130 can be easily altered by, for example, varying the thickness of mask 180. To further illustrate, the configuration of the wick 130 can be altered by changing the manner of application of the wick 130 through, for example, varying the shape of the mask 180. This facilitates the design of the wick 130 at the design stage according to the performance required of the wick 130.

For example, as shown in FIG. 10(a), a mask 2180 may be configured to have a thickness that varies at different positions in the transport direction. To further illustrate, the mask 2180 is configured such that a region 2181 where a wick-shaped opening 2190 is formed decreases in thickness as one moves downstream in the transport direction.

The use of the mask 2180 results in the formation of a wick 2130 as shown in FIG. 10(b). The wick 2130 has a thickness dimension that varies at different positions in the transport direction. Specifically, the wick 2130 is configured to decrease in thickness as one moves downstream in the transport direction.

Alternatively, a wick 2230 may be formed as shown in FIG. 10(c). The material composition of the wick 2230 varies at different positions in the transport direction. To further illustrate, the wick 2230 is configured to have a smaller average aperture size as one moves downstream in the transport direction. To further illustrate, the wick 2230 includes a first portion 2231 with a first average aperture size and a second portion 2233 with a second average aperture size that is different from (smaller than) the first average aperture size.

The wick 2230 has a constant thickness dimension, but is configured such that the first portion 2231 decreases in thickness as one moves downstream in the transport direction, and the second portion 2233 increases in thickness as one moves downstream in the transport direction. Mutually different materials, e.g., with different grain sizes, may be used for the first and second portions 2231, 2233. After application of the material for use as the first portion 2231, the material for use as the second portion 2233 is applied over the first portion 2231, and then the materials are sintered to form the wick 2230.

Still alternatively, a wick 2330 may be formed as shown in FIG. 10(d). The wick 2330 has a structure that varies at different positions in the transport direction. Specifically, the wick 2330 is configured such that its downstream portion in the transport direction has a smaller average aperture size than its upstream portion in the transport direction. In the illustrated example, the average aperture size of the wick 2330 is reduced by pressing a part of the applied material, without using multiple materials. Specifically, after applying a material 2332 for use as the wick 2330 at a certain thickness, only the downstream portion 2333 in the transport direction is pressed (see arrow F3). This results in the downstream portion 2333 in the transport direction having a smaller average aperture size than the upstream portion 2331 in the transport direction. This also results in the downstream portion 2333 in the transport direction having a smaller thickness than the upstream portion 2331 in the transport direction.

Still alternatively, a wick 2430 may be formed as shown in FIG. 10(e). Specifically, a material 2431 for use as the wick 2430 is applied at an inclination such that it becomes thicker (higher) toward the downstream end in the transport direction, and then pressed to level the thickness (see arrow F4). This results in a downstream portion 2437 in the transport direction having a smaller average aperture size than an upstream portion 2435 in the transport direction. In other words, the average aperture size decreases (slopes) as one moves downstream in the transport direction. In the illustrated example, the upstream and downstream portions 2435, 2437 in the transport direction have the identical thickness.

### Electronic Device

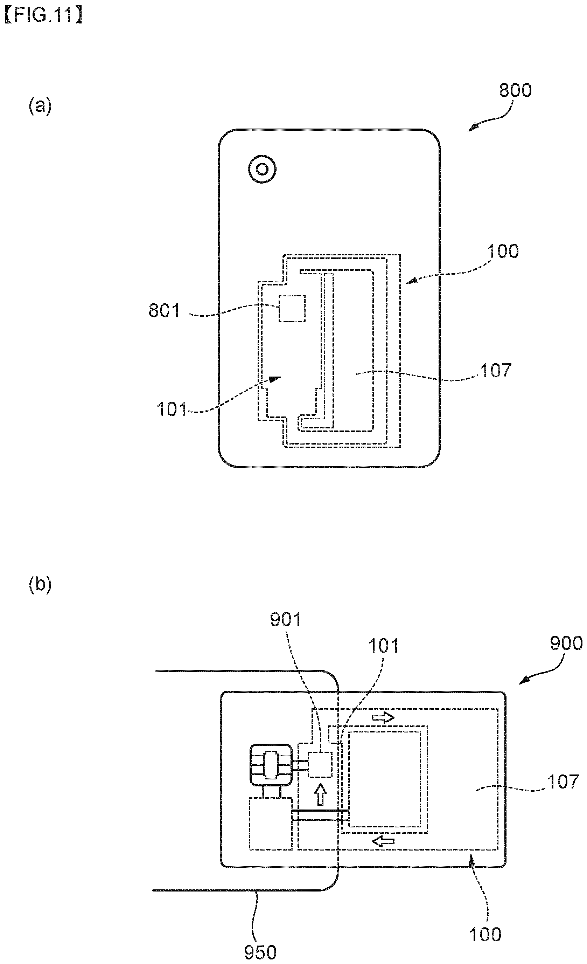

FIGS. 11(a) and 11(b) illustrate devices with the loop heat pipe 100.

Referring next to FIGS. 11(a) and 11(b), devices with the loop heat pipe 100 will be described.

As shown in FIG. 11(a), the loop heat pipe 100 is provided in an electronic device such as a mobile phone 800. The depicted mobile phone 800 is a so-called smartphone. The mobile phone 800 includes a central processing unit (CPU) 801, which is an example of the heating element, and the loop heat pipe 100 to cool the CPU 801. The heat generated by the CPU 801 is controlled by the loop heat pipe 100.

The loop heat pipe 100 does not require an external power supply, as described above. In other words, it can operate without power. In addition, the loop heat pipe 100 may enable a long-distance heat transport (e.g., 100 mm to 1 m) and a highly efficient heat transport using latent heat. In addition, the loop heat pipe 100 is thin, offering layout flexibility.

In recent years, the introduction of the so-called 5th generation mobile communication system (5G) and other factors have led to an increased demand for high-frequency communications (3.7, 4.5, and 28 GHz). And for example, densification through the addition of more components, higher CPU and GPU processing power requirements, increased heat density, and increased heat transport are required of smartphones and tablet terminals such as the mobile phone 800. The loop heat pipe 100 described above is a device that may meet these performance requirements.

While the mobile phone 800 has been described as an example of the electronic device, the above loop heat pipe 100 may be provided in personal computers, tablet terminals, projectors, etc. The loop heat pipe 100 may also be provided in various devices such as electronic control units (ECUs) and batteries installed in automobiles etc., or satellites.

As shown in FIG. 11(b), the loop heat pipe 100 may be installed in a card 900. The card 900 is a so-called smart card, whose specifications are defined by an international standard (ISO/IEC7810).

Smart cards are generally classified into contact and contactless types. Inside the card are 0.4-mm or less thick devices, such as IC chips, near field communication (NFC) antennas, Bluetooth^{®} communication, fingerprint sensors, displays, power supply ICs, DC/DC converters, batteries and capacitors, which are incorporated as needed. In the future, along with the increased performance of IC chips and various devices, smart cards are expected to be used like a PC. The driving power for the PC is received through a card reader 950 in the case of a contact type, and through the NFC antenna in the case of a contactless type. As a CPU 901 for the PC generates more heat with an increase in computing speed, a cooling mechanism needs to be provided within the card 900.

The loop heat pipe 100, which is 0.3 mm thick for example, can be incorporated into the card 900. The loop heat pipe 100 may be configured to reject heat by exposing some of the surfaces of the condenser 107 (e.g., the condensation surface) to the outside of the card 900. To further illustrate, the loop heat pipe 100 can be an effective solution to design problems where the card 900 is a contact type and the CPU 901 for the PC has to be located in a region of the card 900 that will be inside the card reader 950.

### Other Variations

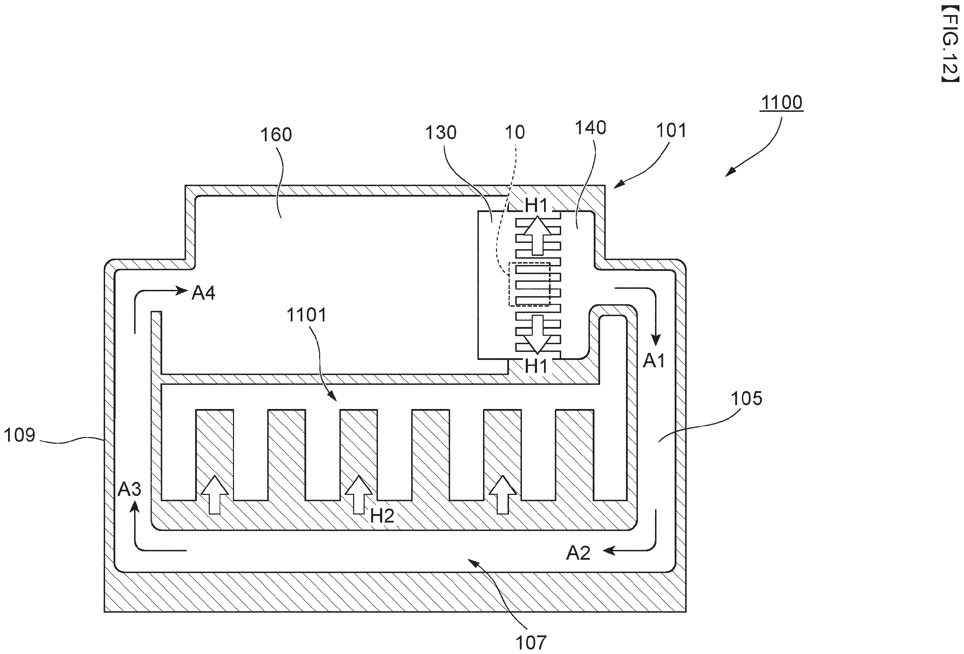

FIG. 12 illustrates a variation of the loop heat pipe 1100.

In the above description, the heat generated in the heating element 10 is dissipated at the condenser 107 of the loop heat pipe 100 via the working fluid. The loop heat pipe 100 may be configured to enable more efficient heat dissipation from the condenser 107. For example, as shown in FIG. 12, a loop heat pipe 1100 may include a fin structure 1101 that increases the heat transfer area, and may be configured to dissipate heat through the fin structure 1101.

In the above description, the mask 180 is used to apply the wick 130. However, this is not limiting. For example, instead of the mask 180, any well-known technique, such as a screen used for screen printing, a dispenser, or the masking tape 280, may be used to apply the wick 130 to a predetermined region. Alternatively, the wick 130 may be formed by forming a sheet (thin plate) of the wick material using a coater and then cutting it into a predetermined shape.

While the wick 130 has been described as being formed by applying it, this is not limiting as to how the wick 130 is formed. For example, the wick 130 may be formed by placing a powdered material of the wick 130 on the first side plate 111 and sintering it. For example, the powdered material may be spread at a thickness of about 0.1 mm on the first side plate 111 at locations where the wick 130 is to be formed. As in the above embodiment, combining the powdered material and a binder into a paste may enable a thin and uniform application of the material of the wick 130.

The material used as the wick 130 is not limited to the porous metal material described above. The wick 130 may be made of any other material, such as a porous ceramic material, porous glass material, or porous fiber, etc., that can be processed into powder and can secure the positions of the components relative to each other when heated.

While the first and second recesses 110, 120 have been described as being formed by etching, this is not limiting. For example, the first and second recesses 110, 120 may be formed by cutting, pressing, or performing any other well-known process on the first and second side plates 111,121. Alternatively, only one of the first and second recesses 110, 120 may be formed, provided that a space for placement of the wick 130 and the bonding member 150 can be provided between the first and second side plates 111, 121. Note that forming the first recess 110 by etching as described above can roughen the first bottom face 114, which may ensure a more reliable securing of the wick 130 to the first side plate 111. Also, forming the second recess 120 by etching can roughen the second bottom face 124, which may ensure a more reliable securing of the bonding member 150 to the second side plate 121.

The first and second side plates 111, 121 are not limited to being generally plate-shaped, provided that are configured to have a reduced thickness dimension. For example, the first and second side plates 111, 121 may have unevenness on their plate surface or may have an additional component(s) secured to their plate surface. To further illustrate, the first and second side plates 111, 121 can be viewed as a body and a lid covering the body, respectively. Alternatively, the loop heat pipe 100 may be formed by sandwiching a frame, separate from the first and second side plates 111, 121, between the first and second side plates 111, 121.

While the bonding member 150 has been described as being formed by applying the material of the bonding member 150 and then sintering it, this is not limiting. For example, the bonding member 150 may be pre-formed as a plate-shaped member, and the plate-shaped bonding member 150 may be secured to the second side plate 121 and the wick 130 by being heated while being sandwiched between the second side plate 121 and wick 130.

While the first and second side plates 111, 121 have been described as being bonded by soldering, this is not limiting. For example, the first and second side plates 111, 121 may be bonded by brazing, provided that it is possible to prevent the flow of brazing material into the first and second recesses 110, 120. Alternatively, diffusion bonding may be used, provided that it is possible to prevent any channel blockage through the provision of a pillar(s) or other means. Still alternatively, bonding may be performed by adhesive bonding, laser bonding, ultrasonic bonding, or friction stir bonding.

While the loop heat pipe 100 has been described as an example of the heat exchanger, this is not limiting and any other two-phase heat transport device may be used. For example, the above configuration of the wick 130, the first side plate 111, etc. may be employed in other heat exchangers such as vapor chambers.

While the various embodiments and variations have been described above, it is readily understood that they may be combined with one another.

It is also understood that teachings of the present disclosure are in no way limited to the above embodiments, and may be implemented in various ways without departing from the scope of the present disclosure.

The loop heat pipe 100 is an example of the heat exchanger. The first side plate 111 is an example of the first plate member and the body. The first recess 110 is an example of the recess. The first metal paste 149 is an example of the powder-containing material and the first material. The wick 130 is an example of the evaporating body. The second side plate 121 is an example of the second plate member and the lid. The wick-shaped opening 190 is an example of the hole. The mask 180 is an example of the covering member. The wick base portion 1131 is an example of the base body. The wick prong 1133 is an example of the downstream body and the protrusion. The first portion 2231 is an example of the first material. The second portion 2233 is an example of the second material. The wick remote portion 337 is an example of the sintered body and another sintered body. The mobile phone 800 is an example of the device. The heating element 10 is an example of the heating component. The second metal paste 159 is an example of the second material. The bonding member 150 is an example of the sintered body and the bonding layer.

### Reference Signs List

- 100: Loop heat pipe
- 111: First side plate
- 121: Second side plate
- 130: Wick
- 150: Bonding member
- 149: First metal paste
- 180: Mask

## Claims

1. A method for manufacturing a heat exchanger including an evaporating body configured to absorb heat from outside and evaporate a liquid-phase working fluid into a gas phase while moving the working fluid by capillary forces, the method comprising steps of:
forming a recess in a plate surface of a first plate member, the first plate member being plate-shaped;
applying a powder-containing material to a predetermined region in the recess;
solidifying the material applied to the predetermined region to form the evaporating body; and
covering the recess having the evaporating body formed thereon with a second plate member, the second plate member being plate-shaped, and securing the first plate member to the second plate member.

2. The manufacturing method according to claim 1, further comprising steps of:
disposing a covering member on the first plate member, the covering member comprising a hole in a surface thereof covering the first plate member, the hole allowing the material to pass therethrough in a shape of the predetermined region; and
applying the material through the hole in the covering member.

3. The manufacturing method according to claim 2, wherein
the evaporating body comprises:
a base body extending in a direction intersecting a moving direction of the liquid-phase working fluid in the evaporating body; and
a plurality of downstream bodies located downstream of the base body in the moving direction, and
the hole is shaped to correspond to the base body and the plurality of downstream bodies.

4. The manufacturing method according to claim 2 or 3, wherein the covering member has a thickness that varies at different positions in a moving direction of the liquid-phase working fluid in the evaporating body.

5. The manufacturing method according to claim 1, wherein the material applied to the predetermined region is in contact with inner side faces of the recess at both ends of the material in a direction intersecting a moving direction of the liquid-phase working fluid in the evaporating body.

6. The manufacturing method according to claim 5, wherein the material applied to the predetermined region is spaced from the inner side faces of the recess at locations upstream, in the moving direction, of portions of the material in contact with the inner side faces of the recess.

7. The manufacturing method according to claim 1, wherein the material applied in the step of applying the material reduces in thickness as one moves downstream in a moving direction of the liquid-phase working fluid in the evaporating body.

8. The manufacturing method according to claim 1, wherein
the step of applying the material comprises a first application step of applying a first material and a second application step of applying a second material over the first material, and
the first material and the second material have a thickness that varies at different positions in a moving direction of the liquid-phase working fluid in the evaporating body.

9. The manufacturing method according to claim 1, further comprising a step of pressing a portion of the material applied to the predetermined region.

10. The manufacturing method according to claim 1, further comprising a step of applying the material to another location than the predetermined region in a channel for the working fluid, wherein
in the step of forming the evaporating body, the material applied to the another location is sintered to form a sintered body, and
the sintered body is sandwiched between the first plate member and the second plate member at the another location.

11. The manufacturing method according to claim 1, wherein the step of forming the recess comprises forming the recess by etching a plate surface of the first plate member.

12. A method for manufacturing a device including a heating component and a heat exchanger, the heat exchanger including an evaporating body configured to absorb heat from the heating component and evaporate a liquid-phase working fluid into a gas phase while moving the working fluid by capillary forces, the method comprising steps of:
forming a recess in a plate surface of a first plate member, the first plate member being plate-shaped;
applying a powder-containing material to a predetermined region in the recess;
solidifying the material applied to the predetermined region to form the evaporating body;
covering the recess having the evaporating body formed thereon with a second plate member, the second plate member being plate-shaped, and securing the first plate member to the second plate member; and
securing the heating component to at least one of the first plate member and the second plate member.

13. A method for manufacturing a heat exchanger including an evaporator provided with an evaporating body configured to absorb heat from outside and evaporate a liquid-phase working fluid into a gas phase while moving the working fluid by capillary forces, the heat exchanger being configured to condense the gas-phase working fluid introduced from the evaporator to circulate the working fluid in a liquid phase into the evaporator, wherein
the evaporator comprises:
a body in which the evaporating body is to be provided; and
a lid covering the body, and
the method comprises steps of:
sintering a first material disposed on the body to form the evaporating body;
sintering a second material disposed on the lid to form a sintered body; and
heating the evaporating body and the sintered body in contact with each other to bond the evaporating body and the sintered body.

14. The manufacturing method according to claim 13, wherein the sintered body covers a portion of the evaporating body, the portion including an upstream side of the evaporating body in a moving direction of the liquid-phase working fluid in the evaporating body.

15. The manufacturing method according to claim 14, wherein
the evaporating body comprises:
a base body extending in a direction intersecting the moving direction; and
a plurality of protrusions projecting downstream in the moving direction from the base body, and
the sintered body does not cover the evaporating body at locations downstream of foots of the protrusions in the moving direction, and covers the evaporating body at locations upstream of the foots of the protrusions in the moving direction.

16. The manufacturing method according to claim 15, wherein
the evaporating body comprises a portion both ends of which in a direction intersecting the moving direction are in contact with inner side faces of the body, and
the sintered body covers the contacting portion.

17. The manufacturing method according to any one of claims 13 to 16, wherein the second material comprises a common composition with the evaporating body and the lid.

18. The manufacturing method according to claim 17, wherein the second material has a lower melting point than the evaporating body and the lid.

19. The manufacturing method according to claim 13, further comprising a step of disposing and sintering the first material at a predetermined location in a channel for the working fluid to form another sintered body sandwiched between the body and the lid at the predetermined location.

20. A method for manufacturing a device including a heating component and a heat exchanger, the heat exchanger including an evaporator provided with an evaporating body configured to absorb heat from the heating component and evaporate a liquid-phase working fluid into a gas phase while moving the working fluid by capillary forces, the heat exchanger being configured to condense the gas-phase working fluid introduced from the evaporator to circulate the working fluid in a liquid phase into the evaporator, wherein
the evaporator comprises:
a body in which the evaporating body is to be provided; and
a lid covering the body, and
the method comprises steps of:
sintering a first material disposed on the body to form the evaporating body;
sintering a second material disposed on the lid to form a sintered body;
heating the evaporating body and the sintered body in contact with each other to bond the evaporating body and the sintered body; and
securing the heating component to at least one of the body and the lid.

21. A heat exchanger including an evaporator provided with an evaporating body configured to absorb heat from outside and evaporate a liquid-phase working fluid into a gas phase while moving the working fluid by capillary forces, the heat exchanger being configured to condense the gas-phase working fluid introduced from the evaporator to circulate the working fluid in a liquid phase into the evaporator, wherein
the evaporator comprises:
a body, the body being a plate-shaped member, the body including a recess in a plate surface thereof, the evaporating body being provided in the recess;
a lid, the lid being a plate-shaped member, the lid being provided on an opposite side of the evaporating body from the body, the lid covering the recess of the body;
a bonding layer located between the lid and the evaporating body provided in the body, the bonding layer being configured to bond the lid and the evaporating body, and
the bonding layer comprises a common composition with the evaporating body and has a lower melting point than the evaporating body.
